Europäisches Patentamt

European Patent Office

Office européen des brevets

(19)

(11) Numéro de publication: **0 237 414 B1**

## FASCICULE DE BREVET EUROPEEN

(12)

(45) Date de publication de fascicule du brevet:
**17.04.91**

(21) Numéro de dépôt: **87400463.3**

(22) Date de dépôt: **03.03.87**

(51) Int. Cl.5: **H03K 23/42**, H03K 23/66,
H03K 3/356

(54) Compteur binaire élémentaire, compteur binaire synchrone et diviseur de fréquence mettant en oeuvre ce compteur élémentaire.

(30) Priorité: **07.03.86 FR 8603287**

(43) Date de publication de la demande:
**16.09.87 Bulletin 87/38**

(45) Mention de la délivrance du brevet:
**17.04.91 Bulletin 91/16**

(84) Etats contractants désignés:
**DE GB NL**

(56) Documents cités:
EP-A- 0 186 533       DE-A- 3 216 712
FR-A- 1 532 207       FR-A- 2 166 483
GB-A- 2 122 785       US-A- 4 037 085

U. Tietze, Ch. Schenk,
"Halbleiter-Schaltungstechnik", 5 edition,
1980, pages 492-494.

W.N. Carr, J.P. Mize, "MOS/LSI design and
Application", ed. par R.E. Sawyer et J.R. Miller, Mc Grew Hill, New York, 1972, pages
128-135.

(73) Titulaire: **THOMSON-CSF**
**51, Esplanade du Général de Gaulle**
**F-92800 Puteaux(FR)**

(72) Inventeur: **Pham Ngu Tung**
**THOMSON-CSF SCPI 19, avenue de Messine**
**F-75008 Paris(FR)**

(74) Mandataire: **Taboureau, James et al**
**THOMSON-CSF SCPI**
**F-92045 Paris La Défense Cédex 67(FR)**

Rank Xerox (UK) Business Services

## Description

La présente invention concerne un compteur binaire synchrone, ainsi qu'un synthétiseur de fréquence qui est obtenu à partir du compteur binaire, en lui faisant diviser sa propre fréquence d'horloge, et en n'utilisant que la dernière sortie du compteur.

Le compteur selon l'invention peut être mis en oeuvre de nombreuses façons, sous forme de composants discrets ou de circuits intégrés, en utilisant des transistors bipolaires ou des transistors à effet de champ, mais il est surtout intéressant dans le domaine des hyperfréquences, sous forme de circuit intégré sur des matériaux rapides, tels que GaAs ou les autres matériaux du groupe III-V.

Il existe plusieurs moyens pour réaliser des compteurs binaires, dont le plus simple est de cascader des diviseurs par 2. Mais pour les divisions de rapports élevés, les derniers étages doivent être très stables, en raison des périodes de plus en plus longues. Or les bascules statiques qui sont utilisées dans l'art antérieur ne sont pas toujours suffisamment stables.

Parmi différentes conceptions possibles pour un compteur binaire, il est connu de le structurer en étages, identiques entre eux et montés en cascade. Par exemple le document DE-A-32 16 712 décrit un compteur binaire en étages, dont chacun comporte un demi-additionneur et une bascule maître-esclave dont la sortie est rebouclée sur une entrée du demi-additionneur. W.N. Carr et J.P. Mize, dans "MOS/LSI design and application", édité par R.E. Sawyer et J.R. Miller, donnent en page 128 le schéma d'un demi-additionneur constitué par trois portes OU inverseuses, dont la structure convient bien aux hyperfréquences. Mais les schémas connus pour les bascules maître-esclave sont trop complexes pour travailler efficacement dans le domaine des gigahertz. Cependant, un schéma simple de bascule est connu de la Demanderesse, qui l'a révélé dans la demande de brevet européen EP-A-0186 533, déposée le 12 novembre 1985 et citée ici selon l'article 54(3) de la CBE : il faut adapter cette bascule à l'environnement d'un compteur binaire.

Le compteur binaire synchrone selon l'invention peut être réalisé avec des bascules statiques, mais également avec des bascules dynamiques, plus rapides, consommant moins et nécessitant moins de composants, ce qui est intéressant pour l'intégration. Mais l'intérêt du circuit de compteur selon l'invention est de fonctionner avec un seul signal d'horloge de fréquence élevée, donc d'être beaucoup plus stable. Plus exactement, les deux signaux d'horloge qui actionnent le compteur sont les deux signaux complémentaires d'une seule horloge: il n'y a donc aucun décalage entre eux, puis qu'ils sont issus d'un seul signal d'horloge.

Le compteur binaire selon l'invention comporte une pluralité d'étages identiques entre eux, montés en cascade. Chaque étage constitue un compteur élémentaire, composé d'un demi-additionneur et d'une bascule maitre-esclave connectée sur la sortie "somme" du demi-additionneur. L'une des entrées du demi-additionneur constitue l'entrée du compteur élémentaire. L'autre entrée du demi-additionneur est réunie à la sortie de la bascule esclave, qui constitue également la sortie du compteur élémentaire. La sortie "retenue" du demi-additionneur constitue l'entrée de l'étage suivant dans le compteur synchrone.

De façon plus précise, l'invention consiste en un compteur binaire élémentaire, à une seule sortie, comportant un demi-additionneur ayant deux entrées, une sortie "somme" et une sortie "retenue", comportant également une bascule maitre-esclave, dont l'entrée est reliée à la sortie "somme" du demi-additionneur et dont la sortie, qui constitue la sortie binaire du compteur, est aussi reliée à la seconde entrée du demi-additionneur, ce compteur étant caractérisé en ce que la bascule "maître-esclave" comporte :
- une première porte OU inverseuse qui reçoit sur ses entrées un signal d'horloge et un signal de synchronisation
- une deuxième porte OU Inverseuse, qui reçoit sur ses entrées le même signal d'horloge et, après Inversion dans un inverseur, le signal de synchronisation,
- une bascule maitre composée de deux transistors à deux grilles, le premier transistor recevant sur ses grilles le signal "somme" issu du demi-additionneur et le signal issu de la première porte OU inverseuse, le second transistor recevant sur ses grilles un signal de forçage et le signal issu de la deuxième porte OU inverseuse
- une bascule esclave composée d'un unique transistor à deux grilles, dont le drain constitue la sortie du compteur binaire élémentaire, et dont une grille reçoit le signal de sortie de la bascule maître et l'autre grille reçoit le signal d'horloge inversé par un inverseur.

L'invention sera mieux comprise, et ses avantages ressortiront de la description suivante d'un compteur binaire synchrone, et d'une application à un synthétiseur de fréquence, en conjonction avec les figures annexées qui représentent :
- figure 1 : schéma de base de diagramme de blocs d'un compteur selon l'invention
- figure 2 : schéma électrique d'un demi-additionneur, utilisé dans un compteur selon l'invention,

- figure 3 : schéma électrique d'une bascule maitre-esclave, utilisée dans un compteur selon l'invention,
- figure 4 : schéma en diagramme de blocs d'un compteur synchrone selon l'invention.

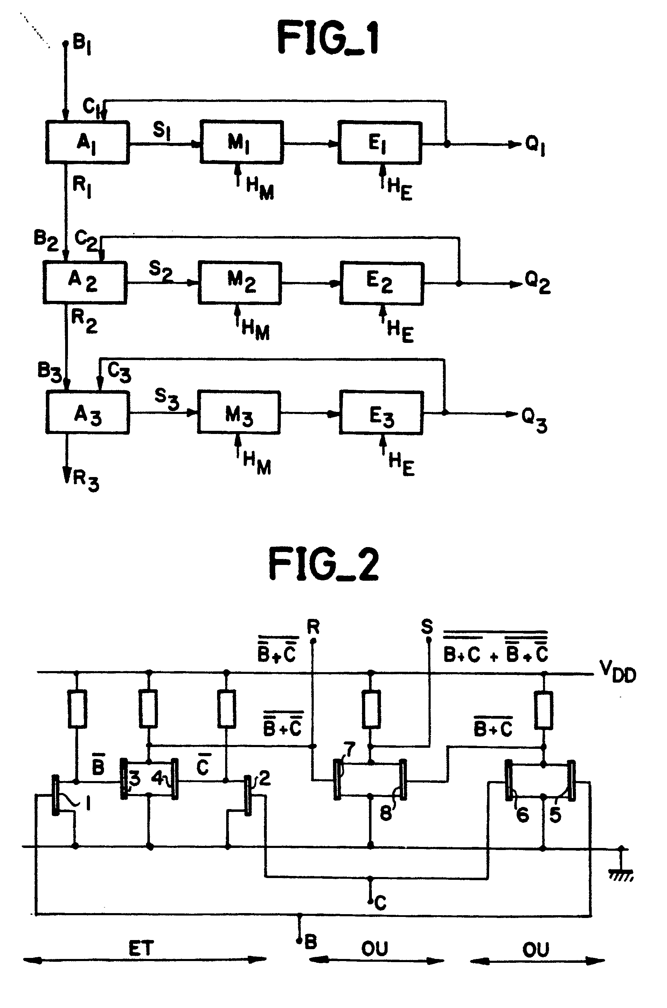

La figure 1 donne le schéma de base d'un compteur binaire selon l'invention. Ce schéma comporte trois étages, dans le seul but de ne pas compliquer la figure, mais ceci ne limite en rien la portée de l'invention : le nombre N d'étages est lié au nombre $2^N$ à compter.

Dans ce compteur, chaque étage constitue un compteur élémentaire, composé d'un demi-additionneur $A_i$ et d'une bascule maitre esclave $M_i$-$E_i$, actionnée par les signaux complémentaires d'une unique horloge. On appellera $H_M$ celui de ces signaux qui commande la bascule maitre, et $H_E = \overline{H}_M$ celui qui commande la bascule esclave.

Un demi-additionneur est constitué par une porte OU exclusif et une porte ET en parallèle : les signaux B et C à additionner sont adressés sur les deux entrées du OU et sur les deux entrées du ET : la sortie S du OU donne la somme, et la sortie R du ET donne la retenue.

Chaque compteur élémentaire comporte donc un demi-additionneur $A_i$, dont la sortie "somme" $S_i$ est recopiée par une bascule maitre-esclave $M_i E_i$, dont la sortie $Q_i$ est rebouclée sur une entrée $C_i$ du demi-additionneur $A_i$. L'autre entrée $B_i$ du demi-additionneur $A_i$ constitue l'entrée de l'étage ou compteur élémentaire. La sortie $Q_i$ de la bascule esclave $E_i$ constitue la sortie de l'étage. La sortie de retenue $R_i$ est adressée à l'entrée de l'étage suivant dans la cascade.

Dans un schéma tel que celui de la figure 1, toutes les sorties $Q_1$, $Q_2$, $Q_3$ sont utilisées si le circuit est utilisé en compteur binaire. Seule la dernière sortie $Q_3$ est utilisée si le circuit est utilisé en diviseur de fréquence.

La table de vérité d'un demi-additionneur est la suivante :

| B | C | S | R |
|---|---|---|---|
| 0 | 0 | 0 | 0 |
| 1 | 0 | 1 | 0 |
| 0 | 1 | 1 | 0 |
| 1 | 1 | 0 | 1 |

La bascule maitre-esclave recopie le signal de somme $S_i$ pour le restituer en $Q_i$ au cycle d'horloge suivant. Pendant le temps où la bascule esclave est lue, on a les relations :
- pour le 1er étage : $Q_1 = C_1$

  $S_1 = B_1 \oplus C_1 = B_1 \oplus Q_1$ (OU exclusif)

  $R_1 = B_1.C_1 = B_1.Q_1 = B_2$ (ET logique)
- pour le 2e étage : $Q_2 = C_2$

  $S_2 = B_2 \oplus C_2 = R_1 \oplus Q_2$

  $R_2 = B_2.C_2 = R_1.Q_2 = B_3$
- pour le 3e étage : $Q_3 = C_3$

  $S_3 = B_3 \oplus C_3 = R_2 \oplus Q_3$

  $R_3 = B_3.C_3 = R_2.Q_3$

Au cycle d'horloge suivant, on a de nouvelles valeurs en sorties :

$Q'_1$ recopie $S_1$

$Q'_2$ recopie $S_2$

$Q'_3$ recopie $S_3$

Il suffit de remplacer $Q_1$, $Q_2$, $Q_3$ par $Q'_1$, $Q'_2$, $Q'_3$ dans les relations précédentes pour avoir de nouvelles valeurs :

$$S'_1 = B_1 \oplus S_1 \text{ parce que } Q_1 \text{ est devenu } Q'_1 = S_1$$

$$R'_1 = B_1 S_1$$

$$S'_2 = R'_1 \oplus S_2 \mid \text{parce que } R_1 \text{ est devenu } R'_1$$

$$R'_2 = R'_1 . S_2 \mid \text{et } Q_2 \text{ est devenu } Q'_2 = S_2$$

$$S'_3 = R'_2 \oplus S_3 \text{ par raisonnement analogue}$$

$$R'_3 = R'_2 . S_3$$

Deux cas sont possibles.

Si $B_1 = 0$ logique, d'après la table de vérité d'un demi-additionneur logique, on a :

$$S'_1 = S_1 \qquad\qquad S'_2 = S_2 \qquad\qquad S'_3 = S_3$$
$$R'_1 = 0 \qquad\qquad R'_2 = 0 \qquad\qquad R'_3 = 0$$

et le compteur reste dans un état identique à l'état qu'il avait auparavant, toutes les entrées $B_1$ et $R_i$ étant à 0 logique.

Si $B_1 = 1$ logique :
$$S'_1 = \overline{S}_1$$
$$R'_1 = S_1$$
$$S'_2 = R'_1 \oplus S_2 = S_1 \oplus S_2$$
$$R'_2 = R'_1 . S_2 = S_1 . S_2 \text{ etc...}$$

Le premier étage a changé de valeur et le compteur a progressé d'une unité.

La progression du compteur ressort du tableau suivant, établie pour un compteur à trois étages. En prenant $B_1 = 1$ logique et comme position de départ $Q_1 = Q_2 = Q_3 = 0$, on calcule $S_1$, $R_1$, $S_2$, $R_2$, $S_3$, $R_3$ à l'aide de la table de vérité d'un demi-additionneur. Au cycle suivant, $Q_1$ recopie $S_1$, $Q_2$ recopie $S_2$, $Q_3$ recopie $S_3$ : on calcule $R_1$, $R_2$, $R_3$ et ainsi de suite, à chaque cycle.

Si $B_1 = 0$ logique, le compteur garde sa dernière valeur et ne change pas.

| Cycle | $B_1$ | $Q_1$ | $S_1$ | $R_1$ | $Q_2$ | $S_2$ | $R_2$ | $Q_3$ | $S_3$ | $R_3$ |
|-------|-------|-------|-------|-------|-------|-------|-------|-------|-------|-------|
| 0 | 1 | 0 | 1 | 0 | 0 | 0 | 0 | 0 | 0 | 0 |
| 1 | 1 | 1 | 0 | 1 | 0 | 1 | 0 | 0 | 0 | 0 |
| 2 | 1 | 0 | 1 | 0 | 1 | 1 | 0 | 0 | 0 | 0 |
| 3 | 1 | 1 | 0 | 1 | 1 | 0 | 1 | 0 | 1 | 0 |
| 4 | 1 | 0 | 1 | 0 | 0 | 0 | 0 | 1 | 1 | 0 |
| 5 | 1 | 1 | 0 | 1 | 0 | 1 | 0 | 1 | 1 | 0 |
| 6 | 1 | 0 | 1 | 0 | 1 | 1 | 0 | 1 | 1 | 0 |
| 7 | 1 | 1 | 0 | 1 | 1 | 0 | 1 | 1 | 0 | 1 |
| 8 | 1 | 0 | 1 | 0 | 0 | 0 | 0 | 0 | 0 | 0 |

Dans ce tableau, les cadres regroupent les entrées et les sorties d'un même compteur élémentaire, ou étage. Les flèches rappellent que la sortie $Q_i$, à un cycle donné, recopie la sortie $S_i$ au cycle précédent.

4

La lecture du compteur se fait sur les sorties $Q_1$, $Q_2$, $Q_3$ des bascules maitre-esclave. Par exemple, au sixième cycle, on a :

$$Q_1 = 0 \qquad \text{poids 0,} \qquad \text{coefficient 0}$$
$$Q_2 = 1 \qquad \text{poids 1,} \qquad \text{coefficient 1}$$
$$Q_3 = 1 \qquad \text{poids 2,} \qquad \text{coefficient 1}$$

ce qui donne un nombre :
$$N = 0.2^0 + 1.2^1 + 1.2^2 = 6$$

Un compteur selon l'invention, formé de N étages ou compteurs élémentaires montés en cascade, peut compter jusqu'à $2^N$.

Ce compteur a en outre l'avantage de disposer de signaux de synchronisation, constitués par la sortie "retenue" $R_N$ du dernier étage : cette sortie n'est pas adressée à un étage suivant, mais son application sera détaillée au cours des figures suivantes. La synchronisation est indispensable pour les remises à zéro automatiques et pour réaliser un diviseur de fréquence programmable.

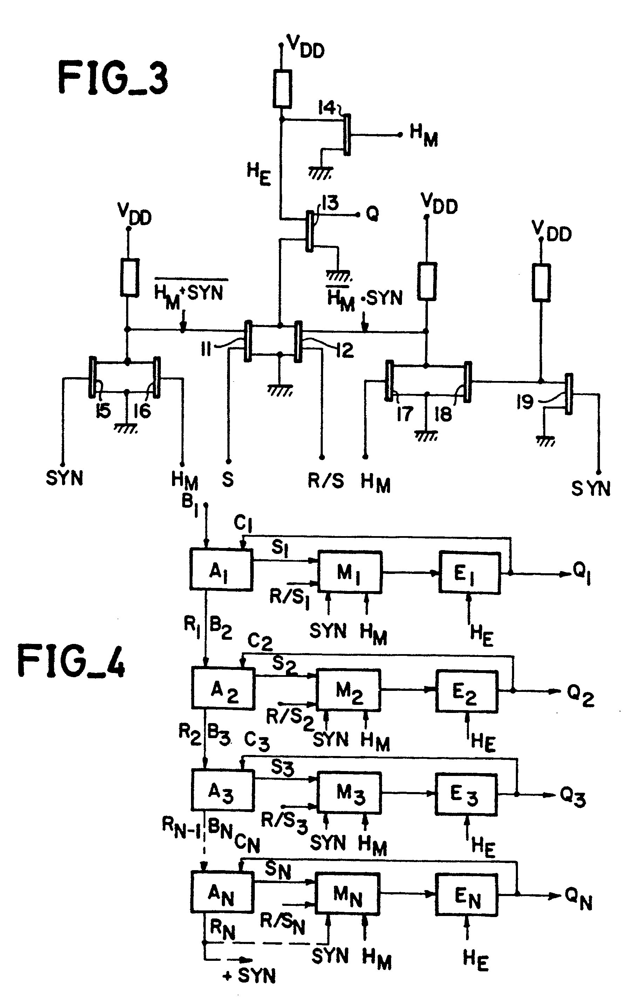

Le compteur selon l'invention, dont le fonctionnement vient d'être exposé, peut être réalisé avec n'importe quel type de demi-additionneurs et de bascules maitre-esclave, mais les figures 2 et 3 en donnent deux schémas d'applications particulièrement intéressants, si les transistors sont des transistors à gaz d'électrons bidimensionnel, et si les résistances de charges sont des charges saturées, c'est-à-dire des transistors sans grilles.

La figure 2 donne le schéma électrique d'un demi-additionneur. Celui-ci comporte deux entrées B et C, et deux sorties "somme" S et "retenue" R.

Cet additionneur est constitué par 8 transistors, connectés en parallèle, sources à la masse -si ce sont des transistors à effet de champ- et dont les drains sont alimentés par une tension $V_{DD}$ à travers des résistances de charges.

La fonction ET est assurée par deux inverseurs 1 et 2, et par un OU inverseur, qui est donc un NOR. Le signal B est adressé sur la grille de l'inverseur 1, dont le drain délivre le complément $\overline{B}$ à la grille du transistor 3 du NOR. Le signal C est adressé sur la grille de l'inverseur 2, dont le drain délivre le complément $\overline{C}$ à la grille du transistor 4 du NOR. Le signal de sortie du NOR est donc :

$$\overline{\overline{B} + \overline{C}} = B.C \ \text{ fonction ET}$$

adressé sur la sortie R du demi-additionneur.

La fonction OU exclusif est assurée par deux OU inverseurs, qui sont donc deux NOR. Les signaux B et C sont adressés, respectivement, sur les grilles de deux transistors 5 et 6 montés en un premier NOR, dont la sortie est donc $\overline{B + C}$.

Enfin, le signal

$$\overline{\overline{B} + \overline{C}}$$

provenant de la fonction ET et le signal $\overline{B + C}$ provenant du premier NOR sont adressés, respectivement, sur les grilles de deux transistors 7 et 8 montés en un second NOR. Le signal "somme" est prélevé sur les drains du second NOR, et le signal "retenue" est prélevé à la sortie du ET. On a bien :

$$S = \overline{\overline{\overline{B} + \overline{C}} + \overline{B + C}} = (\overline{B} + \overline{C}) \cdot (B + C) \qquad (\text{OU exclusif})$$

$$R = \overline{\overline{B} + \overline{C}} = B.C \qquad\qquad\qquad (\text{ET})$$

La figure 3 donne le schéma électrique d'une bascule maitre-esclave, munie d'une entrée de forçage R/S (Reset-Set) synchronisée avec l'horloge $H_M$.

5

La bascule maitre est composée par deux transistors 11 et 12, montés en parallèle, à deux grilles, sources à la masse et drains reliés ensemble.

La grille côté source du transistor 11 constitue l'entrée S de la bascule maitre : elle est réunie à la sortie S du demi-additionneur de la figure 2. La grille coté drain du transistor 11 est commandée par le signal de sortie d'une porte OU inverseuse, formée par deux transistors 15 et 16 : la grille de l'un est commandée par le signal d'horloge $H_M$, et la grille de l'autre est commandée par le signal de synchronisation SYN, qui est la retenue $R_N$ du dernier étage du compteur (voir fig. 4). La grille côté drain du transistor 11 est donc commandée par un signal de forme :

$$\overline{H_M + SYN}$$

La grille côté source de transistor 12 constitue l'entrée de forçage R/S. La grille côté drain du transistor 12 est commandée par le signal de sortie d'une porte OU inverseuse, formée par deux transistors 17 et 18 : la grille du transistor 17 est commandée par le signal d'horloge $H_M$, et la grille du transistor 18 est commandée, à travers un inverseur 19, par le signal de synchronisation SYN. La grille côté drain du transistor 12 est donc commandée par un sginal de forme :

$$\overline{H_M + \overline{SYN}} \text{ soit } \overline{H_M} \cdot SYN$$

Les transistors 11 et 12 sont donc alternativement conducteurs.

La bascule esclave est composée d'un transistor 13, à deux grilles, source à la masse et dont le drain constitue la sortie Q de la bascule maitre-esclave. Dans le schéma de la figure 1, le point Q est rebouclé sur l'entrée C du demi-additionneur, à chaque étage.

La grille côté source du transistor 13 est commandée par le signal issu de la bascule maitre, c'est-à-dire prélevé sur les drains des transistors 11 et 12. La grille côté drain du transistor 13 est commandée par le signal d'horloge $H_E$, complémentaire de $H_M$, à travers un inverseur constitué par un transistor 14.

Bien entendu, pour le demi-additionneur comme pour la bascule maitre-esclave, tous les transistors sont convenablement alimentés à partir d'une source $V_{DD}$, à travers des résistances de charge, mais comme cela est évident, il est inutile de détailler la polarisation, qui peut changer si les transistors utilisés ne sont pas à effet de champs mais bipolaires.

La figure 4 donne le schéma en diagramme de blocs d'un compteur binaire synchrone ou d'un synthétiseur de fréquence : le passage de l'un à l'autre ne nécessite qu'une petite modification qui sera exposée plus loin. Ce schéma est plus complet que celui de la figure 1. Comme dans cette précédente figure, le compteur comporte plusieurs étages en cascade. Dans chaque étage, le demi-additionneur $A_i$ possède deux entrées $B_i$ et $C_i$ et deux sorties "somme" $S_i$ et "retenue" $R_i$. Chaque bascule maitre-esclave possède deux entrées $S_i$ et de forçage R/S, une sortie $Q_i$ et trois entrées de commande $H_M$, $H_E$ ($= \overline{H}_M$) et SYN. Au sein d'un étage, la sortie S de l'additionneur nourrit l'entrée de la bascule, et la sortie Q de la bascule est rebouclée sur l'entrée C de l'additionneur. Entre deux étages, la sortie $R_{N-1}$ d'un étage est cascadée avec l'entrée $B_N$ de l'étage suivant.

Les commandes $H_M$, $H_E$ et SYN sont en fait reliées ensemble, chacune dans sa catégorie.

Dans le fonctionnement de ce circuit en compteur binaire synchrone, l'entrée $B_1$ est l'entrée du circuit pour le nombre à compter, les entrées de forçage $R/S_1...R/S_N$ sont mises à la masse, la sortie $R_N$ du dernier étage est inutilisée. Les sorties du compteur sont les sorties $Q_1...Q_N$ des étages. Le compteur peut être remis à zéro chaque fois qu'un signal 1 logique commande la synchronisation SYN.

Dans le fonctionnement de ce circuit en diviseur programmable, l'entrée $B_1$ est fixée au niveau 1 logique, les entrées de forçage $R/S_1...R/S_N$ sont activées -elles ne sont plus à la masse comme dans le cas précédent- et la sortie $R_N$ du dernier étage est reliée aux entrées de synchronisation SYN -en trait pointillé sur la figure 4-. Le circuit divise sa propre fréquence d'horloge, sortie sur la seule borne $Q_N$.

Si on reprend le tableau de progression établi précédemment, au cycle 7 pour lequel $R_3 = 1$ -pour un compteur à 3 étages bien entendu- on a deux cas :
- si $R/S_1 = R/S_2 = R/S_3 = 0$, la bascule maitre n'est pas forcée :

$$R_3 \quad Q_1 \quad Q_2 \quad Q_3$$

| | $R_3$ | $Q_1$ | $Q_2$ | $Q_3$ |
|---|---|---|---|---|
| Cycle 7 | 1 | 1 | 1 | 1 |
| Cycle 8 | 0 | 0 | 0 | 0 |

Le cycle 8 est identique au cycle 0 : le diviseur divise par 8.
- si $R/S_1 = 1$, $R/S_2 = R/S_3 = 0$, la bascule maitre $M_1$ est forcée

| | $R_3$ | $Q_1$ | $Q_2$ | $Q_3$ |
|---|---|---|---|---|
| Cycle 7 | 1 | 1 | 1 | 1 |
| Cycle 8 | 0 | 1 | 0 | 0 |

Le cycle 8 est identique au cycle 1 : le diviseur, qui a une période de 7, divise par 7.

De façon plus générale, si N est le nombre d'étages d'un circuit diviseur, et si P est le nombre binaire (0 ou 1) de la commande de forçage R/S, le diviseur de fréquence selon l'invention divise dans le rapport $2^N$-P.

Ce type de compteur est d'un emploi très général, et il fonctionne dans une large gamme de fréquences. Cependant, il a été étudié plus spécifiquement en vue d'être intégré, pour des applications dans les domaines de traitements de données en hyperfréquences.

**Revendications**

1. Compteur binaire élémentaire, à une seule sortie, comportant un demi-additonneur ($A_1$) ayant deux entrées ($B_1$, $C_1$) une sortie "somme" ($S_1$) et une sortie "retenue" ($R_1$), comportant également une bascule "maitre-esclave" ($M_1$, $E_1$), dont l'entrée est reliée à la sortie "somme" ($S_1$) du demi-additonneur ($A_1$) et dont la sortie ($Q_1$), qui constitue la sortie binaire du compteur, est aussi reliée à la seconde entrée ($C_1$) du demi additonneur ($A_1$), ce compteur étant caractérisé
    en ce que la bascule "maitre-esclave" ($M_1$ $E_1$) comporte :
    - une première porte OU inverseuse (15,16), qui reçoit sur ses entrées un signal d'horloge ($H_M$) et un signal de synchronisation (SYN)
    - une deuxième porte OU inverseuse (17,18), qui reçoit sur ses entrées le même signal d'horloge ($H_M$) et, après inversion ($\overline{\text{SYN}}$) dans un inverseur (19), le signal de synchronisation,
    - une bascule maitre composée de deux transistors (11,12) à deux grilles, le premier transistor (11) recevant sur ses grilles le signal "somme" (S) issu du demi-additonneur ($A_1$) et le signal

$$\overline{(H_M + \text{SYN})}$$

issu de la première porte OU inverseuse (15,16), le second transistor (12) recevant sur ses grilles un signal de forçage (R/S) et le signal

$$\overline{(H_M + \text{SYN})}$$

issu de la deuxième porte OU inverseuse (17,18)
    - une bascule esclave composée d'un unique transistor (13) à deux grilles, dont le drain constitue la sortie (Q) du compteur binaire élémentaire, et dont une grille reçoit le signal de sortie de la bascule maître (11,12) et l'autre grille reçoit le signal d'horloge ($H_M$) inversé ($H_E$) par un inverseur (14).

2. Compteur binaire synchrone, caractérisé en ce qu'il comporte une pluralité de compteurs binaires

EP 0 237 414 B1

élémentaires selon la revendication 1, montés en cascade, la sortie "retenue" ($R_1$) d'un demi-additionneur ($A_1$) étant connectée sur la première entrée ($B_2$) du demi-additionneur suivant dans la cascade, les sorties ($Q_1$, $Q_2$, $Q_3$) des compteurs élémentaires constituant les sorties binaires du compteur.

3. Compteur binaire synchrone selon la revendication 2, caractérisé en ce que le signal de synchronisation (SYN) appliqué aux bascules maitres ($M_1$, $M_2$, $M_3$) est le signal de retenue ($R_N$) du dernier demi-additonneur ($A_N$) de la pluralité de compteurs binaires élémentaires.

4. Compteur binaire synchrone selon la revendication 2, caractérisé en ce que la remise à zéro se fait au moyen d'un signal 1 logique sur l'entrée de synchronisation (SYN).

5. Diviseur de fréquence programmable, caractérisé en ce qu'il est constitué par un compteur binaire selon la revendication 2, dont l'entrée ($B_1$) est maintenue au niveau 1 logique, dont la sortie "retenue" ($R_N$) du dernier compteur élémentaire est connectée à la ligne de synchronisation (SYN), ce diviseur délivrant sur la sortie ($Q_N$) du dernier compteur élémentaire un signal correspondant à sa propre fréquence d'horloge divisée par un facteur programmé par les valeurs binaires des entrées de forçage ($R/S_1$, $R/S_2$, $R/S_3$).

6. Diviseur de fréquence selon la revendication 5, caractérisé en ce que, si N est le nombre de compteurs élémentaires et si P est le nombre binaire (0 logique ou 1 logique) des entrées de forçage (R/S), ce diviseur divise selon le rapport $2^N - P$.

## Claims

1. An elementary binary counter, having a single output, comprising a half-adder ($A_1$) with two inputs ($B_1$ and $C_1$), a "sum" output ($S_1$) and a "hold" output ($R_1$), also comprising a "master-slave"flipflop ($M_1$ and $E_1$), whose input is connected with the "sum" output ($S_1$) of the half-adder ($A_1$) and whose output ($Q_1$), which constitutes the binary output of the counter, is also connected with the second input ($C_1$) of the half-adder ($A_1$), said counter being characterized in that:
    the "master-slave" flipflop ($M_1$ and $E_1$) comprises:
    - a first inverting OR gate (15 and 16), which receives at its inputs a clock signal ($H_M$) and sync signal (SYN),
    - a second inverting OR gate (17 and 18), which at its inputs receives the same clock signal ($H_M$) and, after inversion ($\overline{SYN}$) in an inverter (19), the sync signal,
    - a master flipflop made up of two transistors (11 and 12) with two gates, the first transistor (11) receiving at its gates the "sum" signal (S) coming from the first half-adder ($A_1$) and the signal

$$(\overline{H_M + SYN})$$

    from the first inverting OR gate (15 and 16), the second transistor (12) receiving at its gates a compelling signal (R/S) and the signal

$$(\overline{M_M + SYN})$$

    from the second inverting OR gate (17 and 18),
    - a slave flipflop made up of a single transistor (13) with two gates, of which the drain constitutes the output (Q) of the elementary binary counter, and of which one gate receives the output signal of the master flipflop (11 and 12) and the other gate receives the clock signal ($H_M$) inverted ($H_E$) by an inverter (14).

2. A synchronous binary counter, characterized in that it comprises a plurality of elementary binary counters as claimed in claim 1, placed in series, the "hold" output ($R_1$) of one half-adder ($A_1$) being connected with the first input ($B_2$) of the following half-adder in the series arrangement, the outputs ($Q_1$, $Q_2$ and $Q_3$) of the counters constituting the binary outputs of the counter.

8

3. The binary synchronous counter as claimed in claim 2, characterized in that the sync signal (SYN) applied to the master flipflops ($M_1$, $M_2$, and $M_3$) is the hold signal ($R_N$) of the last half-adder ($A_N$) of the plurality of elementary binary counters.

4. The synchronous binary counter as claimed in claim 2, characterized in that setting to zero is performed by means of a logical 1 signal at the synchronization input (SYN).

5. A programmable frequency divider, characterized in that it is constituted by a binary counter as claimed in claim 2, whose input ($B_1$) is maintained at the logical 1 level, of which the "hold" output ($R_N$) of the last elementary counter is connected with the sync line (SYN), said divider providing at the output ($Q_N$) of the last elementary counter a signal corresponding to its inherent clock frequency divided by a factor programmed by the binary values of the compelling inputs ($R/S_1$, $R/S_2$ and $R/S_3$).

6. The frequency divider as claimed in claim 5, characterized in that, if N is the number of elementary counters and if P is the binary number (logical 0 or logical 1) of the compelling inputs (R/S), said divider divides in accordance with the ratio $2^N - P$.


## Ansprüche

1. Elementar-Binärzähler mit einem einzigen Ausgang, der einen Halbaddierer ($A_1$) umfaßt, welcher zwei Eingänge ($B_1$, $C_1$), einen Ausgang "Summe" (S1) sowie einen Ausgang "Übertrag" ($R_1$) aufweist, wobei der Zähler ferner eine "Master-Slave"-Kippschaltung ($M_1$, $E_1$) umfaßt, deren Eingang mit dem Ausgang "Summe" ($S_1$) des Halbaddierers ($A_1$) und deren Ausgang ($Q_1$), der den binären Ausgang des Zählers bildet, auch mit dem zweiten Eingang ($C_1$) des Halbaddierers ($A_1$) verbunden ist, wobei dieser Zähler dadurch gekennzeichnet ist, daß die "Master-Slave" Kippschaltung ($M_1$, $E_1$) umfaßt:
   - eine erste OR-Inverter-Schaltung (15, 16), die an ihren Eingängen ein Taktsignal ($H_M$) sowie ein Synchronisationssignal (SYN) empfängt;
   - eine zweite OR-Inverter-Schaltung (17, 18), die an ihren Eingängen dasselbe Taktsignal ($H_M$) und nach einer Inversion ($\overline{SYN}$) in einem Inverter (19) das Synchronisationssignal empfängt;
   - eine Master-Kippschaltung, die aus zwei Transistoren (11, 12) mit zwei Elektroden besteht, wobei der erste Transistor (11) an seinen Elektroden das Signal "Summe" (S), das aus dem Halbaddierer ($A_1$) stammt, sowie das Signal

$$\overline{(H_M + SYN)},$$

das aus der ersten OR-Inverter-Schaltung (15, 16) stammt, empfängt, wobei der zweite Transistor (12) an seinen Elektroden ein Stellsignal (R/S) und das Signal

$$\overline{(H_M + SYN)},$$

das aus der zweiten OR-Inverter-Schaltung (17, 18) stammt, empfängt;
   - eine Slave-Kippschaltung, welche aus einem einzigen Transistor (13) mit zwei Elektroden besteht, dessen Drain den Ausgang (Q) des Elementar-Binärzählers bildet und wovon ein Gate das Ausgangssignal der Master-Kippschaltung (11, 12) und das andere Gate das durch einen Inverter (14) invertierte ($H_E$) Taktsignal ($H_M$) empfängt.

2. Synchroner Binärzähler, dadurch gekennzeichnet, daß er eine Vielzahl von Elementar-Binärzählern nach Anspruch 1 umfaßt, die in Kaskade geschaltet sind, wobei der Ausgang "Übertrag" ($R_1$) eines Halbaddierers ($A_1$) an den ersten Eingang ($B_2$) des in der Kaskade darauffolgenden Halbaddierers angeschlossen ist und die Ausgänge ($Q_1$, $Q_2$, $Q_3$) des Elementar-Zählers die binären Ausgänge des Zählers bilden.

3. Synchroner Binärzähler nach Anspruch 2, dadurch gekennzeichnet, daß das an die Master-Kippschaltungen ($M_1$, $M_2$, $M_3$) angelegte Synchronisationssignal (SYN) das Übertragsignal ($R_N$) des letzten Halbaddierers ($A_N$) der Vielzahl von Elementar-Binärzählern ist.

4. Synchroner Binärzähler nach Anspruch 2, dadurch gekennzeichnet, daß die Rücksetzung auf Null mittels eines logischen Signals 1 an dem Synchronisationseingang (SYN) erfolgt.

5. Programmierbarer Frequenzteiler, dadurch gekennzeichnet, daß er aus einem Binärzähler nach Anspruch 2 gebildet ist, dessen Eingang ($B_1$) auf dem logischen Pegel 1 gehalten wird, dessen Ausgang "Übertrag" ($R_N$) des letzten Elementar-Zählers an die Synchronisationsleitung (SYN) angeschlossen ist, wobei dieser Teiler an dem Ausgang ($Q_N$) des letzten Elementar-Zählers ein Signal abgibt, das seiner eigenen Taktfreguenz, geteilt durch einen Faktor, der durch die Binärwerte der Stelleingänge ($R/S_1$, $R/S_2$, $R/S_3$) programmiert ist, entspricht.

6. Frequenzteiler nach Anspruch 5, dadurch gekennzeichnet, daß, wenn N die Anzahl der Elementarzähler und P die Binärzahl ( logisch 0 oder logisch 1) der Stelleingänge (R/S) ist, dieser Teiler im Verhältnis $2^N - P$ teilt.

# FIG_1

# FIG_2

FIG_3

FIG_4